# FASCICULE DE BREVET EUROPEEN

(11) **EP 1 124 674 B1**
(45) Date de publication et mention de la délivrance du brevet: **10.12.2008**
(21) Numéro de dépôt: 99950888.0
(22) Date de dépôt: 29.10.1999
(51) Int. Cl.: B28D 5/00, B25B 11/00

(54) **PROCEDE ET DISPOSITIF POUR SEPARER EN DEUX TRANCHES UNE PLAQUE DE MATERIAU NOTAMMENT SEMI-CONDUCTEUR**
VERFAHREN UND VORRICHTUNG ZUM SPALTEN EINER PLATTE, AUS INSBESONDERE HALBLEITERMATERIAL, IN ZWEI DÜNNEREN PLATTEN
METHOD AND DEVICE FOR SEPARATING INTO TWO SLICES A WAFER OF MATERIAL, IN PARTICULAR SEMICONDUCTOR MATERIAL

(30) Priorité: 30.10.1998 FR 9813660
(43) Date de publication de la demande: 22.08.2001
(73) Titulaire: S.O.I.Tec Silicon on Insulator Technologies, 38190 Bernin (FR)
(72) Inventeur: LAMURE, Jean-Michel, F-38420 Saint-Jean-le-Vieux (FR); LISSALDE, François, F-38180 Seyssins (FR)
(74) Mandataire: Le Forestier, Eric
(86) Numéro de dépôt international: PCT/FR1999/002658
(87) Numéro de publication internationale: WO 2000/026000

(56) Documents cités:
- DE-C- 225 569
- DE-C- 233 020
- DE-C- 883 875
- GB-A- 2 124 547
- US-A- 3 651 385
- US-A- 4 184 472
- US-A- 5 580 112
- BRUEL M ET AL: "SMART-CUT: A NEW S.O.I. MATERIAL TECHNOLOGY BASED ON HYDROGEN IMPLANTATION AND WAFER BONDING" INTERNATIONAL CONFERENCE ON SOLID STATE DEVICES AND MATERIALS, vol. CONF. 1996, 1 janvier 1996 (1996-01-01), pages 458-460, XP000694069

## Description

L'invention concerne d'une façon générale le domaine du traitement de matériaux, et plus précisément ceux destinés à la fabrication de substrats pour l'électronique, l'optique ou l'optoélectronique, ou encore la fabrication de microsystèmes. En particulier, l'invention concerne un procédé et un dispositif pour effectuer des opérations de séparation selon des plans de fragilisations dans de tels substrats, de manière contrôlée et précise.

Plus précisément encore, elle concerne un procédé et un dispositif pour disjoindre, selon un plan de séparation, deux tranches initialement accolées l'une à l'autre avec des degrés variables de cohésion mécanique.

On connaît des procédés et dispositifs permettant une séparation d'un cristal n'ayant pas de plan de fragilisation, en plusieurs tranches. On peut citer notamment les documents DE 233 020 et US 4 184 472 qui décrivent de tels solutions. Toutefois, ces solutions ne sont pas adaptées pour la fabrication de substrats pour l'électronique, l'optique ou l'optoélectronique ou encore la fabrication de microsystèmes qui nécessitent des tranches ayant une qualité supérieure, notamment en termes de pureté, géométrie ou rugosité.

Un procédé connu de fabrication de substrats SOI (Silicon On Insulator pour silicium sur isolant) comprend une étape d'implantation ionique à une profondeur donnée dans une tranche de silicium monocristallin, une étape de fixation de cette tranche sur un raidisseur tel que du silicium éventuellement oxydé en surface, puis une étape destinée à assurer au moins partiellement une fracture selon le plan de fragilisation définie au niveau de la couche d'ions implantés. (Dans certains cas, si les épaisseurs des deux parties de la tranche de silicium monocristallin situées de part et d'autre du plan de fragilisation sont suffisamment grandes pour présenter en elles-mêmes un minimum de tenue mécanique, l'étape de fixation sur un raidisseur est omise).

Dans ce type de procédé, que la fracture soit complète ou partielle, les deux tranches restent dans la pratique collées l'une à l'autre (par simple effet de ventouse dans le cas où la fracture a été totale), et il demeure nécessaire d'effectuer leur séparation, pour obtenir d'une part le substrat SOI final, qui subira ensuite le cas échéant certains traitements de finition, et d'autre part le reliquat du silicium monocristallin, qui pourra être recyclé dans le procédé.

Une telle séparation doit naturellement être conduite avec les plus grandes précautions, pour assurer un décollement des deux tranches, avec si nécessaire l'achèvement de la fracture, sans risquer de détériorer les deux tranches.

Cette opération est en général effectuée manuellement, par un opérateur particulièrement expérimenté, par exemple en introduisant dans le chant de la plaque, à la hauteur du plan de séparation, une lame acérée ou analogue permettant, par effet de coin, d'assurer le décollement. Cette opération risque d'induire des chocs ou frottements entre les faces en vis-à-vis des deux tranches, et donc de les détériorer. En outre, cette opération manuelle est longue et fastidieuse, et les cadences de production en sont largement tributaires. Enfin, notamment dans le cas où la fracture entre les deux tranches doit être terminée par le processus de séparation lui-même, les sollicitations apportées à la plaque doivent être particulièrement importantes, et l'opération manuelle précitée devient inadaptée, voire dangereuse.

La présente invention vise donc à proposer un procédé et un dispositif qui permettent de réaliser une telle séparation d'une manière rapide, fiable et reproductible, et qui en outre évitent tout contact ou frottement entre les tranches alors qu'elles sont en cours de séparation, et donc tout risque de rayure ou de dépôt de particules sur les faces actives desdites tranches.

Un autre objet de l'invention est de pouvoir effectuer une séparation entre des tranches dont le degré de cohésion mécanique est extrêmement variable, et en particulier entre lesquelles la fracture macroscopique est seulement partielle, sans toutefois avoir à exercer sur la plaque des sollicitations démesurées.

Ainsi, selon un premier aspect, la présente invention propose un procédé pour séparer en deux tranches une plaque de matériau destiné à la fabrication de substrats pour l'électronique, l'optique ou l'opto-électronique ou à la fabrication de microsystèmes, lesdites tranches étant situées de part et d'autre d'un plan de fragilisation, caractérisé en ce qu'il comprend les étapes consistant à :
- exercer sur au moins l'une des tranches une sollicitation de déformation apte à provoquer dans une zone de la plaque, une séparation des tranches l'une par rapport à l'autre au niveau dudit plan de fragilisation ; et
- exercer sur les tranches un mouvement d'écartement guidé.

Grâce à l'invention, en exerçant un effort de déformation, il est possible d'amorcer dans une zone localisée de la plaque, au niveau du plan de fragilisation, une onde de séparation. Celle-ci peut se propager sur toute l'étendue du plan de fragilisation soit dès que la déformation est appliquée, soit lorsque le mouvement d'écartement des deux tranches est commencé, mais dans tous les cas d'une façon extrêmement rapide et sans que des efforts de séparation importants doivent être appliqués.

En effet, si l'on exerçait une traction de part et d'autre des tranches, sur toute leur surface et sans amorçage localisé de la séparation, il faudrait intégrer la force nécessaire à la séparation sur toute la surface, ce qui aboutirait à une force considérable.

Par contre, selon le procédé de l'invention, l'effort à appliquer pour l'écartement proprement-dit est extrêmement limité, ce qui permet d'effectuer cet écartement selon une trajectoire extrêmement bien contrôlée, sans risque de choc ou frottement entre les surfaces séparées, ce qui est particulièrement important lorsque ces surfaces deviendront des surfaces actives, dont les exigences de qualité (pureté, géométrie, etc.) sont particulièrement critiques.

Avantageusement, l'amorçage de la séparation est réalisé en exerçant principalement une contrainte, à proximité d'un bord (ou du bord, lorsque la plaque a une forme de disque), sur au moins l'une des faces de la plaque et non pas sur le flanc de celle-ci, même si selon certaines variantes de l'invention il sera aussi possible de combiner l'application de contraintes sur les faces et sur le flanc.

Ainsi, conformément à un autre but de l'invention, celle-ci permet de séparer les tranches au niveau d'un plan de fragilisation unique et bien déterminé.

On entend, dans ce texte, par « plan de fragilisation », une zone de matériau obtenue par un traitement particulier de ce dernier, et qui s'étend sur une certaine épaisseur perpendiculairement audit plan. Un tel traitement peut comprendre une implantation d'espèces atomiques, la réalisation d'un matériau poreux, etc. Dans tous les cas, il s'agit d'un traitement ayant permis, dans cette zone, de modifier la structure du matériau ou de réaliser une structure particulière de matériau, de manière à ce que la séparation par le procédé, et/ou le dispositif, selon l'invention, s'effectue préférentiellement dans cette zone. Ce plan peut ne pas être un plan cristallin au sens strict du terme et la séparation peut intervenir, au gré des irrégularités du matériau, s'étendre, dans la direction perpendiculaire audit plan, à plusieurs plans cristallins.

Des aspects préférés du procédé selon l'invention sont les suivants :
- l'étape de sollicitation de déformation comprend l'application d'une succion sur au moins l'une des tranches dans une région s'étendant localement à proximité d'un bord de la plaque ;
- l'étape de sollicitation de déformation comprend l'application d'une succion sur au moins l'une des tranches dans une région s'étendant de la proximité d'un bord de la plaque au centre de celle-ci ; avantageusement dans ce cas, la succion est appliquée à l'aide d'un moyen de préhension dont la rigidité est supérieure à celle des tranches à séparer ;
- la déformation se produit avantageusement par application d'une force sur une zone de la plaque, située entre au moins deux points d'appui rigidement solidaires l'un de l'autre ; avantageusement l'amplitude de la déformation dans la direction perpendiculaire aux surfaces principales de la plaque est inférieure à 1 mm et préférentiellement inférieure à 500 µm; cette caractéristique permet de contrôler et limiter les déformations des tranches et les défauts qui pourraient en résulter ;
- l'étape de sollicitation de déformation est avantageusement apte à provoquer une contrainte de cisaillement dans au moins une région du plan de fragilisation ; avantageusement, cette déformation s'effectue par une courbure de la plaque selon une direction perpendiculaire à la surface de celle-ci ;
- l'étape d'écartement comprend le déplacement d'un moyen apte à appliquer ladite succion, selon une direction généralement transversale au plan de la plaque ;
- l'étape d'écartement consiste en un déplacement d'au moins l'une des tranches par translation sans rotation ;
- l'étape d'écartement consiste en un déplacement d'au moins l'une des tranches par translation accompagnée d'une rotation ;
- le procédé comprend en outre une étape de libération d'au moins l'une des tranches par suppression de la succion ;
- le procédé comprend en outre une étape d'application d'une contrainte apte à favoriser la séparation ;
- ladite application d'une contrainte est comprise dans le groupe comprenant l'application d'un gradient thermique, l'application d'une vibration mécanique, l'application d'une attaque chimique, l'application d'une contrainte de cisaillement et l'application d'un flux de fluide à vitesse élevée..

Si la contrainte apte à favoriser la séparation, est une contrainte de cisaillement, celle-ci peut être obtenue par traitement thermique, lorsque les matériaux de part et d'autre du plan de fragilisation, n'ont pas le même coefficient de dilatation thermique ou que ces matériaux n'ont pas la même température. Elle peut également être obtenue par déformation de la plaque, telle qu'une déformation tendant à donner à cette plaque une forme bombée, autour d'une calotte allongée.

La contrainte apte à favoriser la séparation peut correspondre à une combinaison des contraintes précitées, de manière simultanée ou décalée dans le temps.

La sollicitation de déformation et la contrainte apte à favoriser la séparation peuvent être de même nature et correspondre à une opération unique.

Selon un second aspect, l'invention propose un dispositif de séparation en deux tranches d'une plaque de matériau notamment semi-conducteur, lesdites tranches étant situées de part et d'autre d'un plan de fragilisation, caractérisé en ce qu'il comprend :
un moyen de retenue de la plaque au niveau d'une première tranche,
un moyen de sollicitation apte à exercer au moins sur la seconde tranche une sollicitation de déformation de la plaque, et
un moyen pour écarter les tranches l'une de l'autre selon une trajectoire prédéterminée.

Des aspects préférés, mais non limitatifs, du dispositif selon l'invention sont les suivants :
- le moyen de sollicitation et le moyen d'écartement sont constitués par un même organe de préhension ;
- ledit organe de préhension possède un moyen de succion ;
- l'organe de préhension comprend un élément généralement plan dont une face tournée vers ladite tranche possède au moins une cavité à dépression ;
- il est prévu une cavité à dépression unique qui présente une forme généralement allongée et qui est apte à s'étendre entre une région de bord de la plaque et une région centrale de la plaque ;
- le moyen de retenue est constitué par un second organe de préhension s'étendant sensiblement parallèlement au premier organe de préhension ;
- le dispositif comprend en outre un moyen de guidage sur lequel la premier organe de préhension est monté ;
- le dispositif comprend en outre un moyen pour solliciter élastiquement le premier organe de préhension pour l'écarter du second organe de préhension ;
- le dispositif comprend en outre des moyens d'actionnement manuel aptes à solliciter le premier organe de préhension à l'encontre de ladite sollicitation élastique et rapprocher l'un de l'autre les deux organes de préhension ;
- le moyen de guidage et le moyen de sollicitation élastique sont constitués par un même organe ;
- ledit organe est un organe de liaison monobloc constituant un parallélogramme déformable ;
- le dispositif comprend en outre des moyens pour sélectivement supprimer la succion ;

D'autres aspects, buts et avantages du procédé et du dispositif selon l'invention apparaîtront mieux à la lecture de la description détaillée qui suit, faite en référence aux dessins annexés sur lesquels :
- la figure 1 est une vue en perspective d'un premier exemple de dispositif de séparation selon l'invention,
la figure 2a est une vue en élévation d'un ensemble d'une partie de préhension du dispositif de la figure 1 et d'une plaque à séparer en deux tranches,
la figure 2b est une vue en coupe transversale de l'ensemble de la figure 2a,
la figure 2c est une vue en perspective de l'ensemble des figures 2a et 2b,
la figure 3a est une vue en perspective d'une pièce formant parallélogramme déformable pouvant équiper le dispositif de la figure 1,
la figure 3b est une représentation schématique de ce parallélogramme déformable dans une première position,
la figure 3c est une représentation schématique de ce parallélogramme déformable dans une seconde position,
la figure 4a est une vue partielle en coupe selon un plan longitudinal médian de deux organes de préhension situés de part et d'autre d'une plaque lors de l'amorçage d'une séparation,
la figure 4b est une vue partielle en coupe selon un plan transversal aux organes de préhension, dans la même situation,
la figure 5 représente schématiquement la propagation d'une onde de séparation dans la plaque, et
la figure 6 est une vue schématique en perspective d'une deuxième forme de réalisation d'un dispositif selon l'invention.

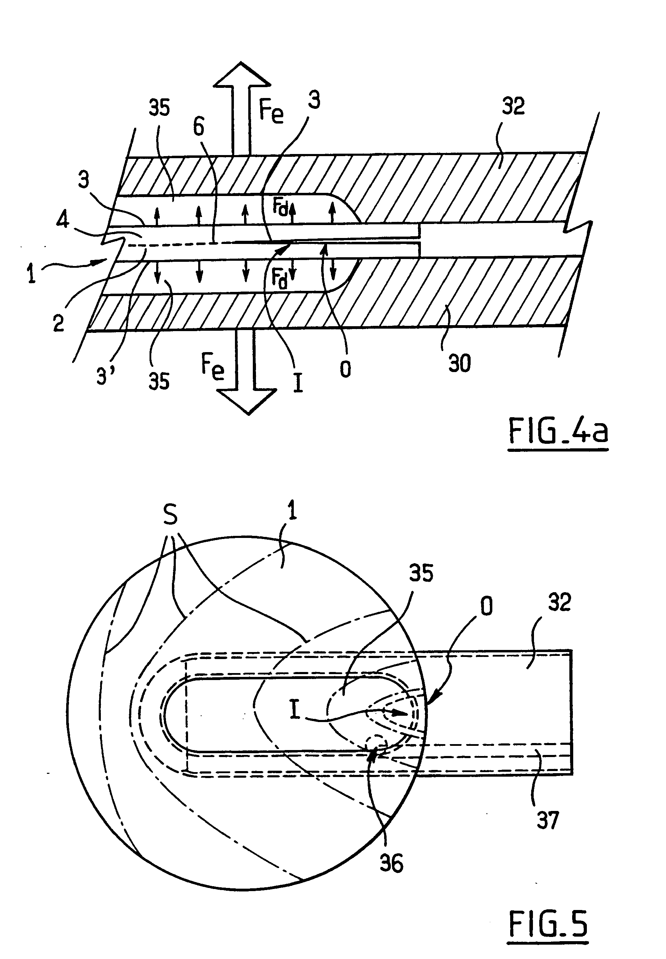

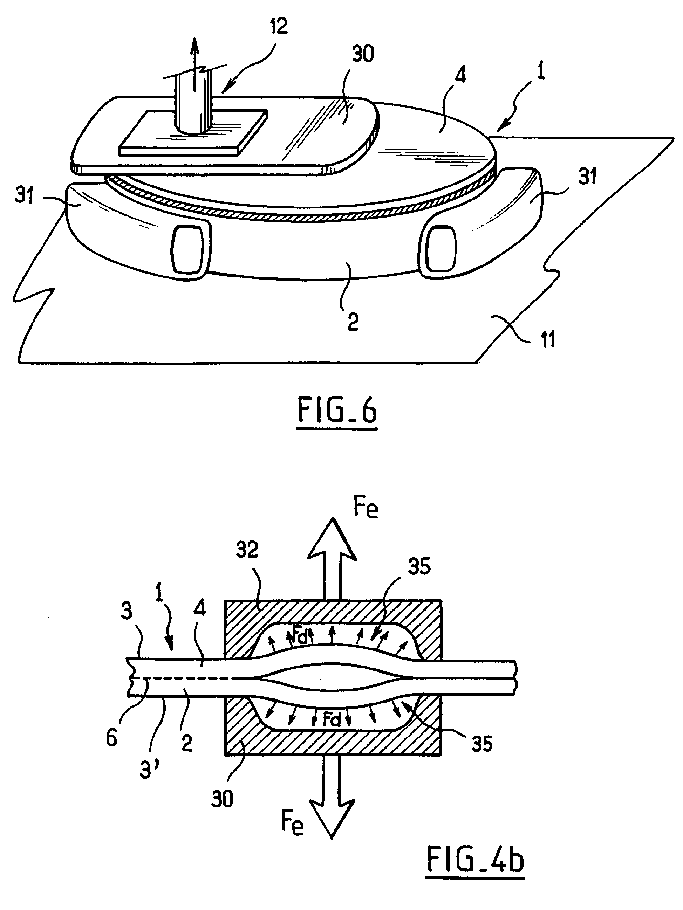

On va maintenant décrire en détail l'invention dans le contexte non limitatif d'une plaque 1 formée par l'assemblage, selon la technique dite du « wafer bonding », d'une tranche de silicium dans laquelle une implantation ionique a été effectuée pour y créer un plan de fragilisation, et d'un raidisseur par exemple en silicium, la tranche de silicium et/ou le raidisseur étant par exemple oxydé en surface au niveau de sa face de liaison. Typiquement, une telle plaque présente un diamètre de 200 mm et une épaisseur de 1500 µm, répartie en général par moitiés entre la tranche de silicium implanté et le raidisseur. Cette plaque comporte deux faces principales 3 et 3' et possède en son sein, au niveau de la profondeur d'implantation dans la tranche de silicium, un plan de fragilisation 6 qui délimite deux tranches 2, 4 à séparer, situées de part et d'autre de ce plan (voir figures 4a et 4b).

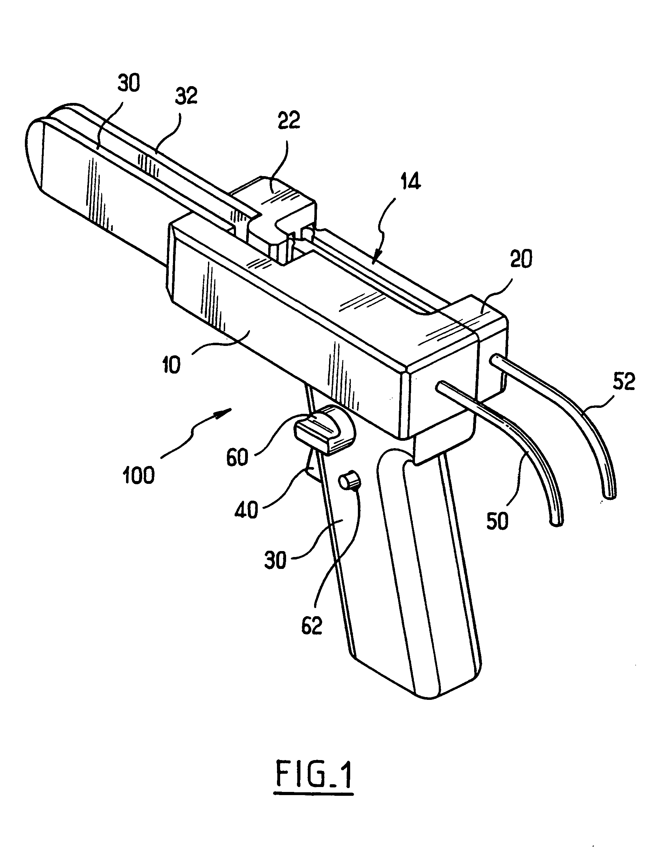

En référence à la figure 1, un dispositif de séparation selon l'invention se présente sous la forme d'un article portable du type pistolet ou pince 100 qui comprend pour l'essentiel un corps principal 10 à partir duquel font saillie deux branches constituant deux organes de préhension 30, 32, et une poignée 30 pourvue d'une gâchette 40, d'un organe de réglage d'écartement 60 et d'un bouton poussoir de libération 62, dont on décrira les fonctions plus loin. Cette pince 100 est reliée par deux tubes d'aspiration 50, 52 à une pompe à vide (non représentée).

La poignée 30 permet à un opérateur de tenir la pince 100 dans une main. Avec cette même main, l'opérateur peut, grâce à la gâchette 40, contrôler le mouvement des organes de préhension 30, 32 comme on le décrira en détail plus loin.

Chacun des organes de préhension 30, 32 est destiné à adhérer par succion sur une face respective 3, 3' de la plaque 1, en réalisant grâce à la pompe à vide une dépression entre ces organes 30, 32 et lesdites faces 3, 3', cette dépression étant suffisante pour exercer, comme on le verra plus loin, des sollicitations autorisant la séparation des deux tranches.

Le corps de pince 10, qui est solidaire de la poignée 30, reçoit de façon fixe l'un 30 des deux organes de préhension. L'autre organe de préhension 32 est relié au corps 10 par l'intermédiaire d'une première pièce de liaison 22, d'une pièce monobloc 14 formant parallélogramme déformable et d'une seconde pièce de liaison 20.

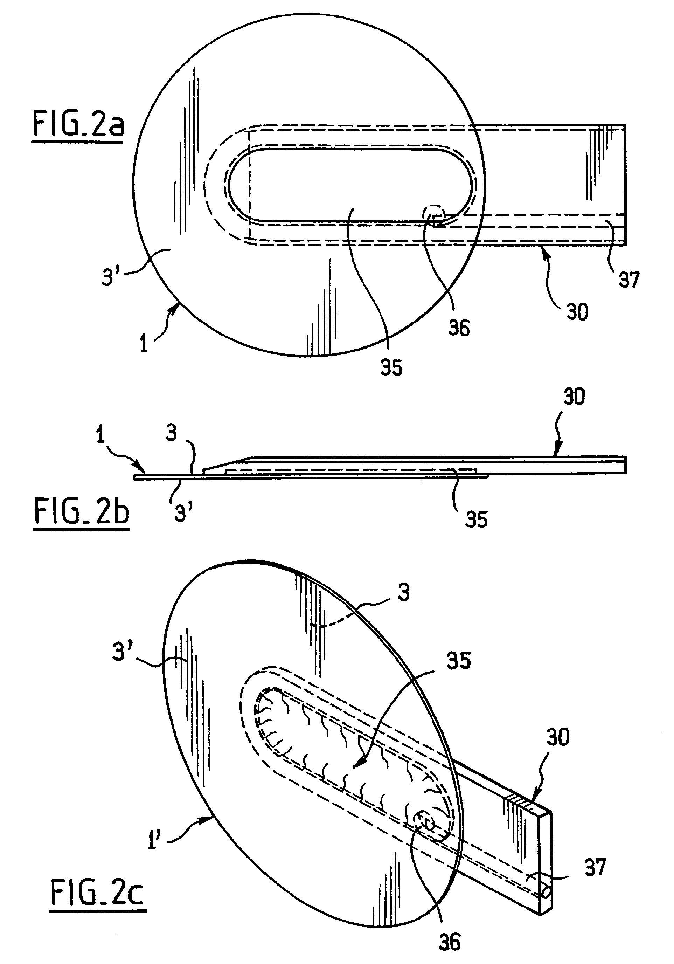

On va maintenant décrire en détail en référence aux figures 2a à 2c l'organe de préhension 30, sachant que l'autre organe 32 est ici conçu de préférence identiquement.

L'organe de préhension 30 est un élément généralement plan et mince, de contour en forme générale de « U », et s'allongeant à partir du corps de pince 10, et possède au niveau d'une face intérieure, c'est-à-dire tournée vers l'autre organe, une cavité à dépression 35, dont le contour est généralement ovale et inscrit dans le contour de l'organe 30. Préférentiellement, cette cavité a une forme de canal fermé à chacune de ses extrémités par une paroi courbe concave. La zone du plan de l'organe de préhension 30 destiné à venir au contact de l'une des surfaces principales de la plaque 1, et correspondant à la surface libre de ce canal s'étend d'une région localement située au bord de la plaque 1 à la région centrale de la plaque 1. La plaque 1, lorsqu'elle est en prise avec de l'organe de préhension 30, repose sur le pourtour de ce canal qui constitue un ensemble de points d'appui, qui du fait de la rigidité de l'organe de préhension 30, sont rigidement solidaires les uns des autres.

Un orifice de mise sous vide 36 débouche dans la cavité d'aspiration 35 au voisinage de l'extrémité de celle-ci la plus proche du corps de pince 10, et communique avec un conduit de mise sous vide 37 noyé dans l'organe de préhension 30 et débouchant à son extrémité opposé sur le bord de l'élément 30 adjacent au corps 10. Ce conduit 37 est relié au flexible 50 de mise sous vide de façon non visible sur la figure 1. Un clapet (également non visible) est interposé sur le trajet de vide et apte à être actionné par le bouton poussoir pour sélectivement effectuer une mise à l'air de la cavité 35 (ainsi de la cavité correspondante de l'autre organe 32), à des fins expliquées plus loin.

Lorsque la cavité d'aspiration 35 est mise en dépression, la plaque a tendance à se déformer et à s'incurver dans la cavité d'aspiration 35 entre les points d'appui correspondant au pourtour de la cavité d'aspiration 35 . La plaque 1 étant généralement d'une certaine rigidité, cette déformation peut éventuellement se propager dans toute la plaque donnant à celle-ci une légère courbure ayant principalement une forme bombée, autour d'une calotte allongée correspondant à la zone obturant la cavité 35. Cette déformation macroscopique de la plaque 1 peut s'accompagner de contraintes favorisant la séparation des tranches (2,4) au niveau du plan de fragilisation.

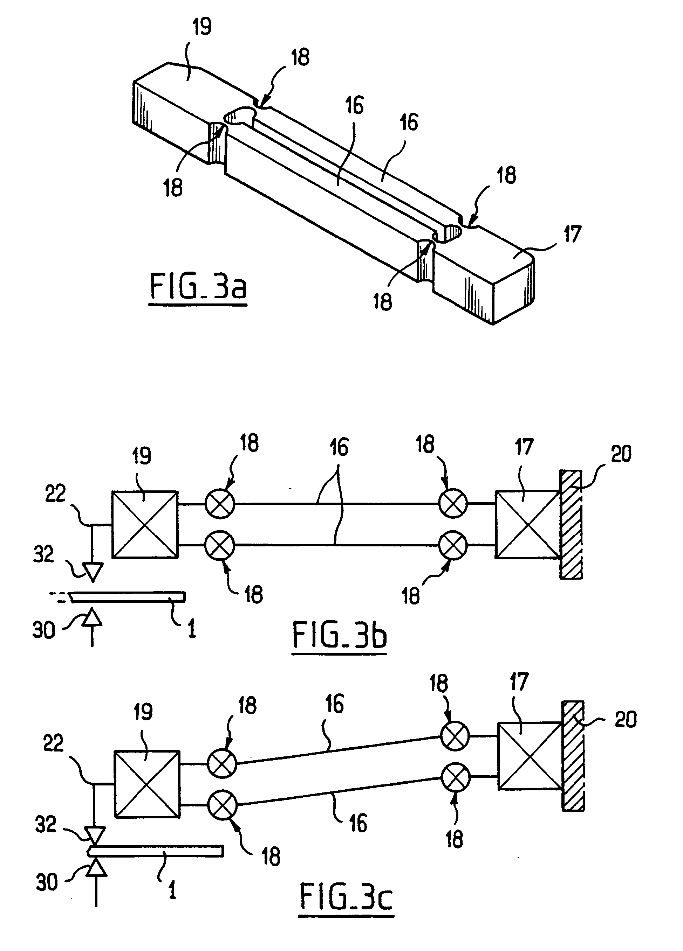

Alors que l'organe de préhension 30 est fixé rigidement sur l'extrémité avant du corps de pince 10, l'organe de préhension 32 est quant à lui déplaçable en étant fixé, par l'intermédiaire d'une pièce de support 22, à l'extrémité libre 19 de la pièce 14 formant parallélogramme déformable, que l'on va maintenant décrire en référence aux figures 3a à 3c. On notera ici que le conduit de vide débouchant dans la cavité à dépression de l'organe 32 est relié au flexible 52 de façon à autoriser les déplacements dudit organe 32.

La pièce 14 présente un contour de forme générale parallélépipédique et comprend deux bras longitudinaux 16 parallèles entre eux, qui relient entre elles les deux parties d'extrémités 17, 19 de ladite pièce au niveau de quatre articulations 18 formées ici par des parties amincies desdits bras. Il s'agit ainsi d'une pièce monobloc, dont le matériau est choisi pour assurer une déformabilité élastique appropriée au niveau des articulations. Les amincissements formant les articulations 18 sont définis entre deux évidements sensiblement semi-circulaires situés en vis-à-vis dans les faces latérales des bras 16 de façon adjacente aux parties d'extrémités 17, 19, en vis à vis, pour ainsi définir des axes privilégiés d'articulation qui, sur la représentation de la figure 3a, sont orientés verticalement.

On définit ainsi un parallélogramme dont les deux grands côtés sont formés par les bras 16, 16, ce parallélogramme étant déformable dans un plan perpendiculaire aux plans des organes de préhension 30, 32 et parallèle aux axes longitudinaux de ces organes.

L'extrémité avant 19 de la pièce 14 est encastrée rigidement dans la pièce de liaison 22 qui porte l'organe de préhension mobile 32, tandis que son extrémité arrière est encastrée rigidement de la pièce de liaison 20, elle même rigidement fixée sur le corps de pince 10.

On comprend donc que le mouvement de la pièce 22, et donc de l'organe de préhension mobile 32, s'effectue lors de la déformation du parallélogramme de telle sorte que le parallélisme entre les organes de préhension 30 et 32 est conservé aussi rigoureusement que possible.

Ainsi les figures 3b et 3c montrent schématiquement les déplacements de la partie 22, et de l'organe de préhension 32, respectivement dans une position espacée où les deux organes de préhension 30, 32 délimitent entre eux un interstice d'une largeur supérieure à l'épaisseur d'une plaque à séparer, et dans une position rapprochée, où les deux organes de préhension 30, 32 délimitent entre eux un interstice d'une largeur inférieure à l'épaisseur de la plaque.

Il est à observer ici que la pièce 14 joue également, dans le présent exemple, le rôle d'un moyen élastique, en étant réalisée en un matériau, tel qu'une matière plastique relativement rigide ou un métal, présentant une élasticité bien déterminée. La pièce est en outre conçue pour que sa forme au repos soit celle qui correspond à la figure 3b, et qu'une sollicitation pour l'amener dans la position illustrée sur la figure 3c engendre en son sein des contraintes de rappel élastique tendant à la ramener vers la position de la figure 3b.

La pince est également équipée de moyens de renvoi d'efforts, non représentés, qui transmettent à la pièce de liaison 22 un effort de pression exercé sur la gâchette 40 de manière à déplacer l'ensemble illustré sur les figures 3a et 3b de la position de la figure 3b vers celle de la figure 3c.

Ces moyens comprennent par exemple une tringlerie appropriée ou un dispositif de transmission d'efforts à came ou à rampe.

Le bouton de réglage 60, comprenant par exemple une molette à vis définissant une butée de fin de course, permet de régler à volonté l'amplitude des mouvements de l'organe de préhension 32. Plus précisément, cette butée est destinée à s'opposer de façon réglable au mouvement de retour de la position de la figure 3c vers la position de la figure 3b, pour ainsi déterminer, en l'absence de pression sur la gâchette 40, la dimension de l'interstice entre les organes de préhension 30, 32 occupant leur position écartée. Ceci permet en particulier de bien adapter l'outil à l'intervalle entre des plaques adjacentes 1 reçues dans un panier commun et destinées à être saisies les unes après les autres pour effectuer la séparation, cet intervalle pouvant varier selon le type de panier.

On va maintenant expliquer en détail en référence aux figures 4a, 4b et 5 l'utilisation et le comportement de la pince de séparation telle que décrite ci-dessus pour séparer une plaque 1 en deux tranches.

La pompe à vide est tout d'abord mise en route pour appliquer un vide aux conduits 50 et 52.

En premier lieu, alors que la pince occupe une position de repos où aucun effort n'est appliqué à la gâchette 40, c'est-à-dire où les organes de préhension occupent leur position espacée, la pince est amenée au droit d'une plaque à séparer, contenue dans un organe de support tel qu'un panier, de manière à ce que lesdits organes 30, 32 se trouvent de part et d'autre de cette plaque et surtout que les cavités 35 de ces deux organes occupent par rapport à la plaque une position voisine de celle illustrée sur les figures 2a à 2c, c'est-à-dire où les extrémités proximales des cavités 35 se situent légèrement en retrait (typiquement de quelques millimètres à un centimètre environ) du bord de la plaque.

On notera ici que cet organe de support peut posséder des aménagements (butées ou analogues) permettant l'indexation de la position des organes 30, 32 par rapport à la plaque, de façon à assurer de façon reproductible le positionnement mutuel de la plaque et des organes 30, 32.

On notera également que la forme de la pince, avec deux organes de préhension minces et saillants, est particulièrement bien adaptée au cas où les plaques 1 à séparer sont placées en succession dans un panier.

L'opérateur exerce alors une pression sur la gâchette 40, ce qui tend à rapprocher les organes de préhension 30, 32 l'un de l'autre, jusqu'à ce que ceux-ci viennent au contact des deux faces 3, 3' de la plaque. Les cavités 35 étant exposées au vide comme décrit plus haut, un effort de succion est exercé sur ces deux faces dès que les organes 30, 32 sont effectivement venus en contact avec elles. Dès lors, les zones des deux faces 3, 3' de la plaque situées au droit des cavités 35 sont exposées au vide créé dans les cavités 35, vide qui exerce sur ces zones des forces Fd qui d'une part vont assurer la retenue de la plaque dans la pince, et qui d'autre part vont tendre à déformer localement la plaque en deux direction opposées.

Il est à observer ici que la planéité des faces internes des deux organes de préhension 30, 32 autour des cavités 35 est assurée avec une précision suffisante pour réaliser l'étanchéité appropriée au niveau de leur interface avec les faces respectives 3, 3' de la plaque 1.

La plaque, alors fermement tenue par la pince, peut être extraite de son support.

L'opérateur relâche alors la pression sur la gâchette 40, si bien que la force de rappel élastique exercée par la pièce 14 tend à solliciter les deux faces de la plaque avec des forces d'écartement Fe selon deux directions opposées essentiellement perpendiculaires au plan de la plaque.

Les forces de déformation Fd et d'écartement Fe précitées se combinent de la façon suivante : tout d'abord, dès la venue en contact des organes de préhension avec les deux faces de la plaque, les forces de déformation, du fait de la forme des cavités, tendent à former dans les deux tranches une convexité selon un axe équivalent de rotation qui s'étend sensiblement le long du grand axe médian de chaque cavité 35. Une telle sollicitation, en s'exerçant à proximité d'un bord de la plaque, permet de créer au niveau de plan de fragilisation 6 une séparation localisée (région 0) définissant un interstice I (de hauteur exagérée sur les figures 4a et 4b par souci de clarté) débouchant sur le bord adjacent de la plaque, ce qui permet de réaliser dans de bonnes conditions l'ouverture de cet interstice. Ensuite, lorsque la gâchette 40 est libérée, les forces d'écartement Fe exercées par les organes de préhension vont provoquer dans la plaque une onde de séparation, pour finalement propager la séparation à partir de la séparation localisée 0 sur toute l'étendue du plan de fragilisation de la plaque. Cette onde de séparation S, illustrée sur la figure 5, se propage à partir d'une zone d'origine O où la séparation a été commencée par les forces de déformation.

Au cours de cette propagation, l'effort exercé par la pièce 14, qui tend à séparer encore davantage les organes de préhension tout en conservant leur parallélisme, assure un décollage progressif des deux tranches de la plaque sans que les faces en vis-à-vis de ces tranches ne soient susceptible de venir à nouveau en contact l'une avec l'autre, pour ainsi éviter de façon fiable tout choc ou frottement susceptible de détériorer la qualité de surface desdites faces.

On observera ici que le moment exact auquel l'onde de séparation se propage peut varier. Ainsi cette onde peut se propager, comme décrit ci-dessus, au moment où l'opérateur relâche la pression sur la gâchette 40, ou bien (selon notamment la taille et la géométrie des cavités) dès le moment où les organes de préhension sont arrivés en contact avec les faces homologues de la plaque pour y exercer les efforts de déformation, ou encore de façon répartie entre ces deux phases.

On va maintenant décrire d'autres formes de réalisation possibles de la présente invention.

Ainsi, sur la figure 6 est représenté une seconde forme de réalisation de l'invention, comportant un support fixe 11 équipé dans le présent exemple de mâchoires 31 conçues pour assurer une retenue périphérique de la plaque 1 seulement sur la hauteur de la tranche inférieure 2 de la plaque 1, ou seulement sur une fraction de cette hauteur. La tranche supérieure est quant à elle assujettie à un organe de préhension 32 analogue à celui équipant la pince décrite plus haut, lui-même fixé à l'extrémité inférieure d'un bras rétractable 12 ou analogue, dont les mouvements par rapport au support 11 sont identiques aux mouvements de la pièce 22 de la pince de la figure 1 par rapport au corps de pince 10.

En variante, la plaque 1 peut être retenue sur le support fixe 11 à l'aide d'une cire, ou encore à l'aide d'un dispositif de retenue électrostatique, de façon connue en soi.

Cette seconde forme de réalisation se prête particulièrement bien à une automatisation des opérations sur une chaîne de fabrication. On peut ainsi multiplier par exemple côte à côte une pluralité de dispositifs de séparation, et prévoir que les bras 12 soient robotisés. L'alimentation en plaques à séparer et l'enlèvement des tranches après séparation sont alors effectués de manière automatisée grâce à des moyens d'approvisionnement et d'évacuation appropriés (cassettes, dispositifs classiques de manipulation de plaquettes, etc.). En particulier, le ou chaque bras 12 est apte à évacuer la tranche 4 que l'organe de préhension 32 retient, après séparation, vers des sites de rangement, de stockage ou de traitement.

Dans le même esprit, la pince décrite en référence aux figures 1 à 5 peut faire partie d'un ensemble de traitement robotisé, chaque organe de préhension étant mobile en étant monté sur un bras de robot et se chargeant de déposer la tranche qu'elle retient après séparation dans un casier de réception approprié. A ce sujet, on peut prévoir de saisir la plaque à séparer avec seulement l'un des organes de préhension, et appliquer seulement ensuite l'autre organe de préhension.

Bien entendu, de nombreuses variantes peuvent être apportées à l'invention.

En premier lieu, les efforts de déformation peuvent être appliqués à la plaque avec des moyens autres qu'une succion, et notamment par l'intermédiaire d'un liquide logé dans une cavité fermée par une membrane et mis en dépression. En outre, ces efforts peuvent être si nécessaire complétés par des forces d'adhésion liés à l'emploi d'un adhésif ou d'une cire entre les organes de préhension et les deux faces de la plaque.

En outre, la forme et le nombre des cavités à dépression 35, de même que la forme des organes de préhension 30, 32 peut largement varier. Ainsi l'on peut créer non pas une amorce de séparation unique au voisinage d'un bord de la plaque, mais deux ou plusieurs amorces de séparation réparties, toujours au voisinage de ce bord, voire une amorce de séparation s'étendant de façon continue sur une partie au moins de la périphérie de la plaque.

Dans tous les cas, il est préférable d'engendrer un gradient de contraintes de déformation tel que ces contraintes diminuent du bord de la plaque 1 vers les zones les plus centrales de celle-ci.

En outre, le mouvement de l'organe de préhension mobile peut s'effectuer par translation pure, comme décrit plus haut, ou encore par translation combinée à une rotation, à la condition bien entendu qu'en chaque point de la plaque on réalise une séparation avec une vitesse non nulle. On comprend donc que la composante de rotation doit se produire autour d'un axe situé à distance de la plaque, et de préférence de façon diamétralement opposée à la zone 0 d'amorce de séparation, de manière à ce que les plus grandes vitesses de séparation aient lieu à ce niveau et à ce que la propagation de l'onde de séparation soit favorisée.

D'une manière plus générale, la répartition des contraintes sur les plaques 1 dépend de la forme, de la taille des tranches 2, 4 à séparer, de la nature des liaisons entre les tranches 2, 4, ainsi que du ou des lieux où l'on souhaite provoquer l'amorce de séparation.

Avantageusement encore, on peut associer au dispositif de l'invention divers moyens de traitement destinés à participer à la séparation ou à la favoriser.

En premier lieu, on peut combiner avec la sollicitation exercée par le dispositif de séparation un traitement qui contribue au moins partiellement à la fracture au niveau du plan de fragilisation, et en particulier un traitement thermique ou un traitement chimique. Un traitement thermique peut favoriser le développement de microcavités et le clivage au niveau du plan de séparation au cours même de la mise en oeuvre du dispositif de séparation. Ce dispositif est alors utilisé en appliquant les organes de préhension 30, 32 sur la plaque 1 et en relâchant la sollicitation sur l'organe 32 pour que les deux organes tendent à s'écarter. Aussi longtemps que les forces de cohésion restent élevées, les deux organes 30, 32 restent en position rapprochée. Dès que le traitement thermique a assuré une fracture suffisante, la sollicitation d'écartement par les deux organes 30, 32 assiste éventuellement cette fracture et écarte alors immédiatement les deux tranches séparées, ce qui en particulier évite les pertes de temps liées, dans un processus classique, au recollement des deux tranches l'une avec l'autre une fois qu'elles ont été clivées.

On combine ainsi avantageusement les étapes de fracture, de séparation et d'écartement, pour simplifier le processus de fabrication.

De la même manière, un traitement par attaque chimique dans des canaux formés au niveau du plan de fragilisation peut être combiné avec la séparation selon l'invention pour simplifier là encore le processus.

Dans chacun des cas (traitement thermique par exemple en introduisant dans un four le dispositif de séparation portant la plaque, ou traitement chimique dans un bain, ou autre), les différents éléments du dispositif de séparation sont naturellement conçus pour résister à l'environnement (notamment chaleur - typiquement quelques centaines de degrés Celsius - ou agent chimique) lié à ce traitement.

Par ailleurs, un tel traitement additionnel peut consister en l'application de contraintes auxiliaires favorisant la séparation. Il peut s'agir notamment de vibrations acoustiques ou ultrasoniques, d'un choc thermique, etc.

Selon une autre variante encore, de la chaleur peut être appliquée à la plaque 1 par au moins un élément de préhension, et des quantités de chaleur différentes peuvent si nécessaire être apportées aux deux faces de la plaque.

Plus généralement, on peut avantageusement utiliser la mise en contact des deux faces de la plaque avec les organes de préhension pour appliquer à la plaque des gradients thermiques contrôlés, soit ascendants, soit descendants. En particulier, le choc thermique précité peut être exercé en utilisant des organes de préhension préalablement refroidis à une température inférieure à celle de la plaque.

Un autre type de contrainte peut également être engendré en appliquant sur le chant de la plaque, au niveau ou doit se former l'amorce de séparation, un flux de fluide (gaz ou liquide) à vitesse élevée, destiné à entrer dans l'interstice de séparation dès sa formation et, par les forces ainsi exercées, favoriser la propagation de l'onde de séparation.

Avantageusement aussi, le dispositif de séparation selon l'invention comprend un capteur de fin de décollement entre les tranches 2, 4, par exemple un contacteur interposé sur le trajet de l'organe de préhension mobile, pour optimiser les cadences et éviter de surexposer les tranches 2, 4 une fois séparées aux éventuels moyens d'application de contraintes auxiliaires. Ceci permet en outre d'éviter un calibrage des durées d'application des contraintes, et d'agir de manière optimale pour chaque plaque 1, sachant que les durées de décollement peuvent dans la pratique varier en fonction des conditions opératoires ou des lots à traiter.

Le procédé et le dispositif selon l'invention peuvent être utilisés, par exemple, mais de manière non limitative, pour la réalisation de substrats de silicium sur isolant. Elle s'applique à la séparation au niveau de plans de fragilisation obtenus d'une façon tout à fait quelconque, avec ou sans traitement thermique, dans tous sortes de matériaux notamment semiconducteurs.

## Revendications

1. Procédé pour séparer en deux tranches (2, 4) une plaque (1) de matériau destiné à la fabrication de substrats pour l'électronique, l'optique ou l'opto-électronique ou à la fabrication de microsystèmes, **comprenant** les étapes consistant à :
- exercer sur au moins l'une des tranches une sollicitation de déformation ; **pour amorcer** une séparation des tranches (2, 4) l'une par rapport à l'autre ; et
- exercer sur les tranches (2,4) un mouvement d'écartement guidé,
**caractérisé par le fait que lesdites tranches sont situées de part et d'autre d'un plan de fragilisation (6),** une force **de succion étant appliquée** sur une zone de la plaque (1) située entre au moins deux points d'appuis rigidement solidaires l'un de l'autre **de manière à créer une dépression** apte à **produire ladite sollicitation de déformation pour amorcer la séparation des tranches (2, 4) l'une par rapport à l'autre au niveau dudit plan de fragilisation.**

2. Procédé selon la revendication 1, **caractérisé par le fait que** l'étape de sollicitation de déformation comprend l'application d'une succion sur au moins l'une des tranches (2, 4) dans une région s'étendant localement à proximité d'un bord de la plaque (1).

3. Procédé selon l'une des revendications précédentes, **caractérisé en ce que** l'étape de sollicitation de déformation comprend l'application d'une succion sur au moins l'une des tranches (2, 4) dans une région s'étendant de la proximité d'un bord de la plaque (1) jusqu'au centre de celle-ci.

4. Procédé selon l'une des revendications 1 à 3, **caractérisé en ce que** l'étape d'écartement comprend le déplacement d'un moyen (32) apte à appliquer ladite succion, selon une direction généralement transversale au plan de la plaque (1).

5. Procédé selon l'une des revendications précédentes, **caractérisé en ce que** l'étape d'écartement consiste en un déplacement d'au moins l'une des tranches (2,4) par translation sans rotation.

6. Procédé selon l'une des revendications 1 à 4, **caractérisé en ce que** l'étape d'écartement consiste en un déplacement d'au moins l'une des tranches (2,4) par translation accompagnée d'une rotation.

7. Procédé selon l'une des revendications 1 à 6, **caractérisé en ce qu'**il comprend en outre une étape de libération d'au moins l'une des tranches (2, 4) par suppression de la succion.

8. Procédé selon l'une des revendications précédentes, **caractérisé en ce qu'**il est mis en oeuvre simultanément à un traitement de fracture selon le plan de fragilisation et/ou une étape d'application d'une contrainte apte à favoriser la séparation.

9. Procédé selon la revendication 8, **caractérisé en ce que** ladite application de contrainte est comprise dans le groupe comprenant l'application d'un gradient thermique, l'application d'une vibration mécanique, l'application d'une attaque chimique, l'application d'une contrainte de cisaillement et l'application d'un flux de fluide à vitesse élevée.

10. Dispositif de séparation en deux tranches (2, 4) d'une plaque (1) de matériau notamment semi-conducteur, **comprenant :**
un moyen (30; 31) de retenue de la plaque (1) au niveau d'une première tranche,
un moyen de sollicitation (30, 32) apte à exercer au moins sur la seconde tranche une sollicitation de déformation **pour amorcer une séparation des tranches (2, 4) l'une par rapport à l'autre** , et
un moyen (40, 14) pour écarter les tranches (2, 4) l'une de l'autre selon une trajectoire prédéterminée,
**caractérisé par le fait que lesdites tranches (2, 4) sont situées de part et d'autre d'un plan de fragilisation (6), et que le moyen de sollicitation est apte à appliquer une force de succion** sur une zone de la plaque (1) située entre au moins deux points d'appuis rigidement solidaires **l'un de l'autre de manière à créer une dépression apte à produire ladite sollicitation de déformation pour amorcer la séparation des tranches (2, 4) l'une par rapport à l'autre au niveau dudit plan de fragilisation.**

11. Dispositif selon la revendication 10, **caractérisé en ce que** le moyen de sollicitation et le moyen d'écartement sont constitués par un même organe de préhension (32).

12. Dispositif selon la revendication 11, **caractérisé en ce que** ledit organe de préhension (32) possède un moyen de succion (35).

13. Dispositif selon la revendication 12, **caractérisé en ce que** l'organe de préhension (32) comprend un élément généralement plan dont une face tournée vers ladite tranche possède au moins une cavité à dépression (35).

14. Dispositif selon la revendication 13, **caractérisé en ce qu'**il est prévu une cavité à dépression unique (35) qui présente une forme généralement allongée et qui est apte à s'étendre entre une région de bord de la plaque (1) et une région centrale de la plaque (1).

15. Dispositif selon l'une des revendications 13 et 14, **caractérisé en ce que** la cavité à dépression (35) est apte à déformer la plaque 1 de manière à tendre à lui donner une forme bombée, autour d'une calotte allongée.

16. Dispositif selon l'une des revendications 13 à 15, **caractérisé en ce que** le moyen de retenue (30, 31) est constitué par un second organe de préhension (30) s'étendant sensiblement parallèlement à un premier organe de préhension.

17. Dispositif selon la revendication 16, **caractérisé en ce qu'**il comprend en outre un moyen de guidage (14) sur lequel le premier organe de préhension (32) est monté.

18. Dispositif selon l'une des revendications 16 et 17, **caractérisé en ce qu'**il comprend en outre un moyen (14) pour solliciter élastiquement le premier organe de préhension pour l'écarter du second organe de préhension.

19. Dispositif selon la revendication 18, **caractérisé en ce qu'**il comprend en outre des moyens d'actionnement manuel (40) aptes à solliciter le premier organe de préhension à rencontre de ladite sollicitation élastique et rapprocher l'un de l'autre les deux organes de préhension.

20. Dispositif selon la revendication 17 prise en combinaison avec l'une des revendications 18 et 19, **caractérisé en ce que** le moyen de guidage et le moyen de sollicitation élastique sont constitués par un même organe (14).

21. Dispositif selon la revendication 20, **caractérisé en ce que** ledit organe (14) est un organe de liaison monobloc constituant un parallélogramme déformable.

22. Dispositif selon l'une des revendications 10 à 21, **caractérisé en ce qu'**il comprend en outre des moyens (62) pour sélectivement supprimer la succion.

## Claims

1. A method of separating into two wafers (2, 4) a plate (1) of material for manufacturing substrates for electronics, optics, or opto-electronics, or for manufacturing microsystems, the method comprising the steps consisting in:
• exerting a deformation force on at least one of the wafers to start separation of the wafers (2, 4) from each other; and
• exerting guided separation movement on the wafers (2, 4) ;
the method being **characterized by** the fact that said wafers are situated on either side of a plane of weakness (6), a suction force being applied to a zone of the plate (1) situated between at least two thrust points that are rigidly secured to each other so as to create suction suitable for producing said deformation force to start the separation of the wafers (2, 4) from each other in said plane of weakness.

2. A method according to claim 1, **characterized by** the fact that the step of exerting a deformation force comprises applying suction on at least one of the wafers (2, 4) in a region extending locally close to an edge of the plate (1).

3. A method according to any preceding claim, **characterized in that** the step of applying deformation comprises applying suction to at least one of the wafers (2, 4) in a region extending from close to an edge of the plate (1) to the center thereof.

4. A method according to any one of claims 1 to 3, **characterized in that** the separation step comprises moving means (32) suitable for applying said suction in a direction that extends generally transversely to the plane of the plate (1).

5. A method according to any preceding claim, **characterized in that** the separation step consists in moving at least one of the wafers (2, 4) in translation without rotation.

6. A method according to any one of claims 1 to 4, **characterized in that** the separation step consists in moving at least one of the wafers (2, 4) in translation accompanied by rotation.

7. A method according to any one of claims 1 to 6, **characterized in that** it further includes a step of releasing at least one of the wafers (2, 4) by eliminating the suction.

8. A method according to any preceding claim, **characterized in that** it is implemented simultaneously with cleavage treatment on the plane of weakness and/or with a step of applying stress suitable for favoring separation.

9. A method according to claim 8, **characterized in that** said application of stress is taken from the group comprising: applying a temperature gradient, applying mechanical vibration, applying chemical etching, applying shear stress, and applying a flow of fluid at high speed.

10. Apparatus for separating a plate (1) of material, in particular of semiconductor material, into two wafers (2, 4), said apparatus comprising:
• means (30; 31) for holding the plate (1) via a first wafer;
• stress-applying means (30, 32) suitable for exerting deformation stress on at least the other wafer to start separation of the wafers (2, 4) from each other; and
• means (40, 14) for moving the wafers (2,4) apart from each other along a predetermined path, the apparatus being **characterized by** the fact that said wafers are situated on either side of a plane of weakness (6) and the stress applying means are suitable for applying a suction force to a zone of the plate (1) situated between at least two thrust points that are rigidly secured to each other so as to create suction suitable for producing said deformation force to start the separation of the wafers (2, 4) from each other in said plane of weakness.

11. Apparatus according to claim 10, **characterized in that** the stress-applying means and the separation means are constituted by the same gripping member (32).

12. Apparatus according to claim 11, **characterized in that** said gripping member (32) possesses suction means (35).

13. Apparatus according to claim 12, **characterized in that** the gripping member (32) includes a generally plane element whose face directed towards said wafer possesses at least one suction cavity (35).

14. Apparatus according to claim 13, **characterized in that** a single suction cavity (35) is provided that is generally elongate in shape and that is suitable for extending between an edge region of the plate (1) and a central region of the plate (1).

15. Apparatus according to claim 13 or 14, **characterized in that** the suction cavity (35) is capable of deforming the plate (1) tending to give the plate a convex shape around an elongate cap.

16. Apparatus according to any one of claims 13 to 15, **characterized in that** the holding means (30, 31) is constituted by a second gripping member (30) extending substantially parallel to a first gripping member.

17. Apparatus according to claim 16, **characterized in that** it further includes guide means (14) on which the first gripping member (32) is mounted.

18. Apparatus according to claim 16 or 17, **characterized in that** it further includes means (14) for resiliently urging the first gripping member away from the second gripping member.

19. Apparatus according to claim 18, **characterized in that** it further includes manual actuator means (40) suitable for urging the first gripping member against said resilient urging so as to move the two gripping members towards each other.

20. Apparatus according to claim 17, read in combination with claim 18 or 19, **characterized in that** the guide means and the resilient urging means are constituted by the same member (14).

21. Apparatus according to claim 20, **characterized in that** said member (14) is a single-piece link member constituting a deformable parallelogram.

22. Apparatus according to any one of claims 10 to 21, **characterized in that** it further includes means (62) for selectively eliminating the suction.

## Patentansprüche

1. Verfahren zum Auftrennen in zwei Scheiben (2, 4) einer Materialplatte (1), die für die Herstellung von Substraten für die Elektronik, die Optik oder die Optoelektronik oder zur Herstellung von Mikrosystemen vorgesehen ist, das die Phasen umfasst, die aus folgendem bestehen:
- Ausüben einer Verformungseinwirkung auf wenigstens eine der Scheiben, um ein Abtrennen der Scheiben (2, 4) voneinander einzuleiten; und
- Ausüben einer geführten Bewegung zum Auseinanderbringen auf die Scheiben (2, 4),
**dadurch gekennzeichnet, dass** die Scheiben sich auf beiden Seiten einer Schwächungsebene (6) befinden, wobei eine Ansaugkraft auf eine Zone der Platte (1) angewendet wird, die sich derart zwischen wenigstens zwei Auflagepunkten befindet, die starr miteinander verbunden sind, dass ein Unterdruck erzeugt wird, der dazu geeignet ist, die Verformungseinwirkung hervorzurufen, um das Abtrennen der Scheiben (2, 4) voneinander im Bereich der Schwächungsebene einzuleiten.

2. Verfahren nach Anspruch 1, **dadurch gekennzeichnet, dass** die Phase der Verformungseinwirkung die Anwendung eines Ansaugvorgangs auf wenigstens eine der Scheiben (2, 4) in einem Bereich umfasst, der sich lokal in der Nähe eines Rands der Platte (1) erstreckt.

3. Verfahren nach einem der vorhergehenden Ansprüche, **dadurch gekennzeichnet, dass** die Phase der Verformungseinwirkung die Anwendung eines Ansaugvorgangs auf wenigstens eine der Scheiben (2, 4) in einem Bereich umfasst, der sich von nahe einem Rand der Platte (1) bis zu deren Zentrum erstreckt.

4. Verfahren nach einem der Ansprüche 1 bis 3, **dadurch gekennzeichnet, dass** die Phase des Auseinanderbringens die Bewegung eines Mittels (32), das dazu geeignet ist, den Ansaugvorgang anzuwenden, umfasst, wobei die Bewegung in einer Richtung stattfindet, die im Wesentlichen quer zur Ebene der Platte (1) ist.

5. Verfahren nach einem der vorhergehenden Ansprüche, **dadurch gekennzeichnet, dass** die Phase des Auseinanderbringens aus einer Bewegung wenigstens einer der Scheiben (2, 4) durch eine Translation ohne Rotation besteht.

6. Verfahren nach einem der Ansprüche 1 bis 4, **dadurch gekennzeichnet, dass** die Phase des Auseinanderbringens aus einer Bewegung wenigstens einer der Scheiben (2, 4) durch eine Translation in Verbindung mit einer Rotation besteht.

7. Verfahren nach einem der Ansprüche 1 bis 6, **dadurch gekennzeichnet, dass** es außerdem eine Phase der Freigabe wenigstens einer der Scheiben (2, 4) durch ein Abschalten des Ansaugvorgangs umfasst.

8. Verfahren nach einem der vorhergehenden Ansprüche, **dadurch gekennzeichnet, dass** es gleichzeitig mit einer Bearbeitung zum Aufbrechen entlang der Schwächungsebene und/oder einer Phase der Anwendung einer Beanspruchung, die dazu geeignet ist, die Trennung zu unterstützen, eingesetzt wird.

9. Verfahren nach Anspruch 8, **dadurch gekennzeichnet, dass** die Anwendung der Beanspruchung aus der Gruppe ist, die folgendes umfasst: die Anwendung eines thermischen Gradienten, die Anwendung einer mechanischen Vibration, die Anwendung einer chemischen Bearbeitung, die Anwendung einer Scherungsbeanspruchung und die Anwendung eines Fluidflusses mit hoher Geschwindigkeit.

10. Vorrichtung zum Auftrennen in zwei Scheiben (2, 4) einer Materialplatte (1), insbesondere aus einem Halbleitermaterial, folgendes umfassend:
ein Mittel (30, 31) zum Festhalten der Platte (1) im Bereich einer ersten Scheibe,
ein Einwirkungsmittel (30, 32), das dazu geeignet ist, wenigstens auf die zweite Scheibe eine Verformungseinwirkung auszuüben, um ein Abtrennen der Scheiben (2, 4) voneinander einzuleiten; und
ein Mittel (40, 14), um die Scheiben (2, 4) entlang einer vorbestimmten Bahn auseinander zu bringen,
**dadurch gekennzeichnet, dass** die Scheiben (2, 4) sich auf beiden Seiten einer Schwächungsebene (6) befinden und dass das Einwirkungsmittel dazu geeignet ist, eine Ansaugkraft auf eine Zone der Platte (1) anzuwenden, die sich derart zwischen wenigstens zwei Auflagepunkten befindet, die starr miteinander verbunden sind, dass ein Unterdruck erzeugt wird, der dazu geeignet ist, die Verformungseinwirkung hervorzurufen, um das Abtrennen der Scheiben (2, 4) voneinander im Bereich der Schwächungsebene einzuleiten.

11. Vorrichtung nach Anspruch 10, **dadurch gekennzeichnet, dass** das Einwirkungsmittel und das Mittel zum Auseinanderbringen durch ein und dasselbe Greiforgan (32) gebildet werden.

12. Vorrichtung nach Anspruch 11, **dadurch gekennzeichnet, dass** das Greiforgan (32) ein Ansaugmittel (35) umfasst.

13. Vorrichtung nach Anspruch 12, **dadurch gekennzeichnet, dass** das Greiforgan (32) ein im Wesentlichen ebenes Element umfasst, von dem eine zu der Scheibe gerichtete Seite wenigstens eine Unterdruckaussparung (35) umfasst.

14. Vorrichtung nach Anspruch 13, **dadurch gekennzeichnet, dass** eine einzige Unterdruckaussparung (35) vorgesehen ist, die eine im Wesentlichen lang gestreckte Form hat und die dafür eingerichtet ist, sich zwischen einem Randbereich der Platte (1) und einem zentralen Bereich der Platte (1) zu erstrecken.

15. Vorrichtung nach einem der Ansprüche 13 und 14, **dadurch gekennzeichnet, dass** die Unterdruckaussparung (35) dazu geeignet ist, die Platte (1) derart zu verformen, dass sie darauf abzielt dieser in der Umgebung einer lang gestreckten Kalotte eine gewölbte Form zu geben.

16. Vorrichtung nach einem der Ansprüche 13 bis 15, **dadurch gekennzeichnet, dass** das Mittel (30, 31) zum Festhalten durch ein zweites Greiforgan (30) gebildet wird, das sich im Wesentlichen parallel zu einem ersten Greiforgan erstreckt.

17. Vorrichtung nach Anspruch 16, **dadurch gekennzeichnet, dass** sie außerdem ein Führungsmittel (14) umfasst, auf dem das erste Greiforgan (32) montiert ist.

18. Vorrichtung nach einem der Ansprüche 16 und 17, **dadurch gekennzeichnet, dass** sie außerdem ein Mittel (14) umfasst, um elastisch auf das erste Greiforgan einzuwirken, um dieses vom zweiten Greiforgan wegzuführen.

19. Vorrichtung nach Anspruch 18, **dadurch gekennzeichnet, dass** sie außerdem Mittel zur manuellen Betätigung (40) umfasst, die dazu geeignet sind, auf das erste Greiforgan entgegen der elastischen Einwirkung einzuwirken und die beiden Greiforgane einander anzunähern.

20. Vorrichtung nach Anspruch 17 in Kombination mit einem der Ansprüche 18 und 19, **dadurch gekennzeichnet, dass** das Führungsmittel und das Mittel zum elastischen Einwirken durch ein und dasselbe Element (14) gebildet werden.

21. Vorrichtung nach Anspruch 20, **dadurch gekennzeichnet, dass** das Element (14) ein in einem Stück ausgeführtes Verbindungselement ist, das ein verformbares Parallelogramm bildet.

22. Vorrichtung nach einem der Ansprüche 10 bis 21, **dadurch gekennzeichnet**, das sie außerdem Mittel (62) umfasst, um den Ansaugvorgang wahlweise zu unterbrechen.
